# EUROPÄISCHE PATENTSCHRIFT

(11) **EP 2 474 209 B1**
(45) Veröffentlichungstag und Bekanntmachung des Hinweises auf die Patenterteilung: **31.10.2018**
(21) Anmeldenummer: 10755076.6
(22) Anmeldetag: 01.09.2010
(51) Int. Cl.: H05K 1/14

(54) **VERFAHREN ZUM VERBINDEN EINER MEHRZAHL VON ELEMENTEN EINER LEITERPLATTE, LEITERPLATTE SOWIE VERWENDUNG EINES DERARTIGEN VERFAHRENS**
METHOD FOR CONNECTING A PLURALITY OF ELEMENTS OF A CIRCUIT BOARD, CIRCUIT BOARD, AND USE OF SUCH A METHOD
PROCÉDÉ PERMETTANT DE CONNECTER PLUSIEURS ÉLÉMENTS D'UNE CARTE DE CIRCUIT IMPRIMÉ, CARTE DE CIRCUIT IMPRIMÉ ET UTILISATION D'UN TEL PROCÉDÉ

(30) Priorität: 03.09.2009 AT 55209 U
(43) Veröffentlichungstag der Anmeldung: 11.07.2012
(73) Patentinhaber: AT & S Austria Technologie & Systemtechnik Aktiengesellschaft, 8700 Leoben-Hinterberg (AT)
(72) Erfinder: THUMSER, Christoph, A-8010 Graz (AT); FREYDL, Gerhard, A-8700 Leoben (AT)
(74) Vertreter: Miksovsky, Alexander
(86) Internationale Anmeldenummer: PCT/AT2010/000316
(87) Internationale Veröffentlichungsnummer: WO 2011/026165

(56) Entgegenhaltungen:
- WO-A1-2009/068741
- DE-U1-202004 018 336
- US-A1- 2002 152 609
- US-A1- 2008 144 299
- US-A1- 2009 014 205

## Beschreibung

Die vorliegende Erfindung bezieht sich auf ein Verfahren zum Verbinden einer Mehrzahl von Elementen einer Leiterplatte, umfassend die folgenden Schritte:
- Bereitstellen der miteinander zu verbindenden Elemente einer Leiterplatte mit aufeinander abgestimmten Konturen,
- Anordnen der miteinander zu verbindenden Elemente in einer räumlichen Nahebeziehung an wenigstens einem Umfangsbereich mit zueinander komplementären Kontur unter Einhaltung eines Abstands zwischen den zueinander gewandten Umfangsbereichen, und
- mechanisches Verbinden durch Verkleben der zueinander gewandten Umfangsbereiche über wenigstens einen Teilbereich derselben zur Verbindung der miteinander zu verbindenden Elemente der Leiterplatte, wobei die miteinander zu verbindenden Elemente einer Leiterplatte zur Durchführung des Verbindungsvorgangs auf einem Trägerelement angeordnet bzw. abgestützt werden, die miteinander zu verbindenden Leiterplattenelemente während des Verbindungsvorgangs an dem Trägerelement durch Anlegen eines Vakuums, durch ein Klemmen, durch ein Eintreten von von dem Trägerelement vorragenden Erhebungen bzw. Stiften in komplementäre Ausnehmungen der Elemente gesichert gehalten werden und/oder die zu den abzustützenden Elementen gerichtete Oberfläche des Trägerelements aus einem ein Verrutschen verhindernden Material, beispielsweise Silikon, Gummi oder dgl., gebildet bzw. damit beschichtet ist, dadurch gekennzeichnet, dass der Abstand zwischen den zueinander gewandten und miteinander zu verbindenden Umfangsbereichen mit maximal 500 µm, insbesondere maximal 200 µm gewählt wird.

Die Erfindung bezieht sich weiters auf eine Leiterplatte, welche aus einer Mehrzahl von miteinander verbundenen Elementen besteht, wobei wenigstens zwei miteinander zu verbindende Elemente der Leiterplatte an wenigstens einem Umfangsbereich derselben unter Einhaltung eines Abstands und unter Abstützung auf einem Trägerelement miteinander durch Verklebung mechanisch verbunden sind, dadurch gekennzeichnet, dass der Abstand zwischen den zueinander gewandten und miteinander zu verbindenden Umfangsbereichen mit maximal 500 µm, insbesondere maximal 200 µm gewählt ist, sowie auf eine Verwendung eines derartigen Verfahrens zur Herstellung einer mehrteiligen Leiterplatte.

Im Zusammenhang mit der Herstellung von Leiterplatten ist es bekannt, eine Mehrzahl von Leiterplatten bzw. Leiterplattenelementen auf einem gemeinsamen, plattenartigen Element herzustellen, wobei derartige Leiterplatten üblicherweise jeweils aus einer Mehrzahl von leitenden und isolierenden Schichten und/oder in einer derartigen Leiterplatte integrierten Bauteilen bestehen. Gemäß derart bekannten Herstellungsverfahren erfolgt ein im wesentlichen vollflächiger Aufbau einer Mehrzahl von Leiterplatten auf dem gemeinsamen plattenartigen Element, worauf nach Fertigstellung der Leiterplatten, diese voneinander getrennt werden. Hiebei weist jede Leiterplatte an ihrem Umfangsrand und somit außerhalb eines ein tatsächliches Leiterplattenelement bildenden, im wesentlichen zentralen Bereichs, in welchem die Strukturen zum Aufbau der Leiterplatte und/oder elektronische Bauteile integriert sind, einen entsprechenden Randbereich auf. Dieser Randbereich ist beispielsweise vorgesehen, um weitere Bearbeitungsschritte einer derartigen Leiterplatte, wie beispielsweise im Rahmen einer Bestückung mit an wenigstens einer Oberfläche festzulegenden Komponenten und/oder eines Einbaus in eine elektrische oder elektronische Vorrichtung durchzuführen, um eine Handhabung und insbesondere ein automatisches Ergreifen einer derartigen Leiterplatte im Rahmen nachfolgender Be- bzw. Verarbeitungsschritte zu ermöglichen. Gemäß derzeit bekannten Verfahrensführungen ist somit davon auszugehen, dass der für den Rahmen bzw. Randbereich der Leiterplatte zur Verfügung zu stellende Umfangsbereich ebenfalls aus üblicherweise kostspieligem Material entsprechend der üblicherweise mehrlagigen Leiterplatte hergestellt wird. Ein derartiger Rand- bzw. Umfangsbereich, welcher für die Funktion der Leiterplatte im Hinblick auf einen üblicherweise mehrlagigen Aufbau aus kostspieligen Materialien nicht erforderlich ist, führt jedoch zu erhöhten Kosten einer derartigen Leiterplatte. Darüber hinaus werden im Rahmen von bekannten Herstellungsverfahren von Leiterplatten zwischen einzelnen Leiterplattenelementen liegende Bereiche bzw. Flächen des gemeinsamen plattenartigen Elements als Abfall verworfen, so dass auch in diesem Zusammenhang erhöhte Kosten für die Herstellung der Leiterplatten bzw. Leiterplattenelemente auflaufen.

Darüber hinaus ist es im Zusammenhang mit der Herstellung von Leiterplatten beispielsweise bekannt, einzelne schadhafte Leiterplatten aus einem gemeinsamen plattenartigen Element zu entfernen, falls diese im Verlauf von Tests bzw. Überprüfungen als schadhaft erkannt wurden, und anstelle von derartigen entfernten schadhaften Leiterplatten einzelne Leiterplatten einzusetzen.

Darüber hinaus sind Verfahren zum gemeinsamen Bearbeiten und Handhaben von Leiterplatten bekannt, wonach in die Leiterplatten jeweils am gesamten Umfang umgebende Rahmenelemente üblicherweise mehrere Leiterplatten bzw. Leiterplattenelemente eingesetzt und daran beispielsweise durch ein Verkleben festgelegt werden. Hiebei kann beispielsweise auf die DE-A 196 00 928, die US-PS 4,689,103, die US-PS 5,044,615, die US-PS 5 866 852 oder die WO 2009/068741 verwiesen werden. Nachteilig bei diesen bekannten Verfahren zum Einsetzen von Leiterplatten in ein die Leiterplatten jeweils vollständig umgebendes Rahmenelement ist insbesondere die Tatsache, dass die für die Anordnung und Preßpassung der Leiterplatten in dem Rahmenelement vorzusehenden Aufnahmeöffnungen exakt an die Abmessungen und Formen der einzusetzenden Leiterplatten unter Einhaltung geringer Fertigungstoleranzen angepaßt werden müssen und dadurch eine ordnungsgemäße Positionierung und Festlegung beispielsweise mit Hilfe einer Verklebung an den Umfangsrändern der üblicherweise eine vergleichsweise geringe Dicke aufweisenden Leiterplatten und Rahmenelemente äußerst schwierig und aufwendig ist.

Ein Verfahren und eine Leiterplatte der eingangs genannten Art sind darüber hinaus der US 2002/0152609 A1 zu entnehmen, wobei insbesondere auf den Austausch defekter Leiterplatten abgezielt wird.

Darüber hinaus ist es bekannt, einzelne Leiterplatten aus einer Mehrzahl von Elementen, welche beispielsweise entsprechend den obigen Ausführungen hergestellt wurden, zusammenzusetzen, wobei derartige Elemente beispielsweise in unterschiedlichen Verfahrensschritten bzw. Herstellungsverfahren hergestellt wurden, wie dies beispielsweise der US 2008/0144299 A1 oder der US 2009/0014205 A1 entnehmbar ist.

Weiters es ist für ein gemeinsames Bearbeiten von Leiterplatten bzw. Leiterplattenelementen bekannt, in einer Bearbeitungsstraße auf einer gemeinsamen Transportstrecke liegende Leiterplattenelemente provisorisch miteinander zu verbinden, wie dies beispielsweise der WO 03/005785 zu entnehmen ist, wobei nach erfolgter Bearbeitung derartiger in einer gemeinsamen Transportebene angeordneter mehrerer Leiterplattenelemente eine Trennung der miteinander verbundenen Leiterplatten bzw. Leiterplattenelemente vorgenommen wird.

Die Erfindung zielt darauf ab, die Probleme von bekannten Ausführungsformen insbesondere im Zusammenhang mit einer passgenauen Verbindung mehrerer Leiterplattenelemente zu verhindern bzw. zu minimieren. Insbesondere zielt die vorliegende Erfindung darauf ab, ein Verfahren sowie eine Leiterplatte der eingangs genannten Art zur Verfügung zu stellen, bei welchen eine Verbindung von wenigstens zwei Elementen zu einer gemeinsamen Leiterplatte vereinfacht und unter Vermeidung von engen bzw. genauen Herstellungstoleranzen günstigerweise weitestgehend automatisiert vorgenommen werden kann.

Zur Lösung dieser Aufgaben ist ein Verfahren zum Verbinden einer Mehrzahl von Elementen einer Leiterplatte der eingangs genannten Art im wesentlichen dadurch gekennzeichnet, dass der Abstand zwischen den zueinander gewandten und miteinander zu verbindenden Umfangsbereichen mit maximal 500 µm, insbesondere maximal 200 µm gewählt wird.

Da nach einem Bereitstellen von miteinander zu verbindenden Elementen einer Leiterplatte mit aufeinander abgestimmten Konturen die zu verbindenden Elemente unter Einhaltung eines Abstands zwischen den zueinander gewandten und miteinander zu verbindenden Umfangsbereichen angeordnet und in weiterer Folge mechanisch verbunden, insbesondere verklebt werden, wird sichergestellt, dass auch bei Einhaltung geringerer Herstellungstoleranzen und somit bei vereinfachter und rascherer Herstellung der Elemente eine zuverlässige Verbindung von miteinander zu verbindenden Elementen einer Leiterplatte erzielbar ist. Es lassen sich somit beispielsweise in unterschiedlichen Verfahrensschritten hergestellte oder herzustellende Elemente einer Leiterplatte einfach und zuverlässig auch im Hinblick auf die Kontur von miteinander zu verbindenden Umfangsbereichen bereitstellen, so dass nicht die für ein Preßpassen erforderlichen engen bzw. genauen Herstellungstoleranzen beachtet werden müssen, wie dies bei den eingangs genannten Ausführungsformen entsprechend dem Stand der Technik erforderlich war. Darüber hinaus wird durch die Einhaltung eines Abstands auch ein entsprechender Raum bzw. Freiraum insbesondere für ein Einbringen eines Klebers zur Verfügung gestellt, wodurch wiederum unter Vereinfachung der Bearbeitungs- bzw. Verbindungsschritte eine raschere Verbindung derartiger Elemente einer Leiterplatte und insbesondere Automatisierung der Verbindung erzielbar bzw. möglich ist. Für eine zuverlässige Abstützung der miteinander zu verbindenden Elemente und somit Unterstützung bei einer Automatisierung wird erfindungsgemäß vorgeschlagen, dass die miteinander zu verbindenden Elemente einer Leiterplatte zur Durchführung des Verbindungsvorgangs auf einem Trägerelement angeordnet bzw. abgestützt werden. Für eine Sicherung einer zumindest provisorischen Positionierung einzelner Elemente auf dem Trägerelement vor einer endgültigen Verbindung von miteinander zu verbindenden Elementen wird darüber hinaus vorgeschlagen, dass die miteinander zu verbindenden Leiterplattenelemente während des Verbindungsvorgangs an dem Trägerelement durch Anlegen eines Vakuums, durch ein Klemmen, durch ein Eintreten von von dem Trägerelement vorragenden Erhebungen bzw. Stiften in komplementäre Ausnehmungen der Elemente oder dgl. gesichert gehalten werden. Zur wenigstens provisorischen Sicherung bzw. Positionierung der miteinander zu verbindenden Elemente der Leiterplatte auf dem Trägerelement wird erfindungsgemäß alternativ oder zusätzlich vorgeschlagen, dass die zu den abzustützenden Elementen gerichtete Oberfläche des Trägerelements aus einem ein Verrutschen verhindernden Material, beispielsweise Silikon, Gummi oder dgl., gebildet bzw. damit beschichtet ist.

Unter Berücksichtigung der üblicherweise geringe Abmessungen aufweisenden Elemente einer Leiterplatte sowie von einzuhaltenden Produktionstoleranzen, welche auch im Rahmen von automatisierten Herstellungsprozessen zu beachten sind, wird gemäß der vorliegenden Erfindung vorgeschlagen, dass der Abstand zwischen den zueinander gewandten und miteinander zu verbindenden Umfangsbereichen mit maximal 500 µm, insbesondere maximal 200 µm gewählt wird. Durch Einhaltung eines derartigen Abstands zwischen miteinander zu verbindenden Umfangsbereichen wird sichergestellt, dass eine zuverlässige und relative Positionierung einzelner derartiger Leiterplattenelemente auch automatisiert erzielbar ist, wobei ein derartiger Abstand auch unter Einhaltung von vergleichsweise großen Produktionstoleranzen sicher erzielbar und einhaltbar ist. Darüber hinaus ermöglicht die Wahl eines derartigen erfindungsgemäß vorgeschlagenen Abstands auch ein einfaches und zuverlässiges Einbringen von beispielsweise Kleber in zumindest Teilbereiche von miteinander zu verbindenden Umfangsbereichen der miteinander zu verbindenden Elemente. Weiters erlaubt die Einhaltung eines derartigen erfindungsgemäß vorgeschlagenen geringen Abstands zwischen miteinander zu verbindenden Elementen auch die Berücksichtigung von Anforderungen im Hinblick auf eine Miniaturisierung der herzustellenden Leiterplatten bzw. Leiterplattenelemente.

Für eine ordnungsgemäße relative Positionierung von miteinander zu verbindenden Elementen wird gemäß einer weiters bevorzugten Ausführungsform vorgeschlagen, dass miteinander zu verbindende Elemente unter Bezugnahme auf wenigstens ein an einem der miteinander zu verbindenden Elemente angeordnetes Ausricht- bzw. Registrierungselement angeordnet und miteinander verbunden werden. Ein derartiges Ausricht- bzw. Registrierungselement kann beispielsweise von einer Öffnung bzw. Durchbrechung auf wenigstens einem von miteinander zu verbindenden Elementen gebildet sein. Für den Fall einer Bearbeitung bzw. Verarbeitung von jeweils einer Vielzahl von gegebenenfalls jeweils aus mehreren Elementen bestehenden Leiterplatten ist darüber hinaus bekannt, bei derartigen tafel- bzw. paneelartigen Anordnungen von mehreren Leiterplatten eine entsprechende Mehrzahl von Ausricht- bzw. Positionierungselementen zur Verfügung zu stellen, um derart eine zuverlässige Positionierung einer Mehrzahl von Elementen zu ermöglichen.

Für eine zuverlässige und rasche Verbindung von miteinander zu verbindenden Elementen einer Leiterplatte wird darüber hinaus vorgeschlagen, dass zum Verkleben ein thermisch oder chemisch oder mittels UV-Licht oder IR-Licht aushärtender Kleber verwendet wird, wie dies einer weiters bevorzugten Ausführungsform des erfindungsgemäßen Verfahrens entspricht.

Unter Berücksichtigung der Elemente einer Leiterplatte und insbesondere im Hinblick auf isolierende oder Kunststoffschichten einer derartigen, insbesondere mehrlagigen Leiterplatte, welche entsprechend den gewählten Materialien während nachfolgender Bearbeitungsschritte beispielsweise nicht übermäßig hohen Temperaturen ausgesetzt werden dürfen, wird gemäß einer weiters bevorzugten Ausführungsform vorgeschlagen, dass ein thermisches Aushärten des Klebers bei einer Temperatur zwischen 80 °C und 300 °C vorgenommen wird.

Um eine zuverlässige und gezielte Anordnung des zur Verbindung der miteinander zu verbindenden Elemente eingesetzten Klebers zu erzielen, wird gemäß einer weiters bevorzugten Ausführungsform vorgeschlagen, dass ein Kleber hoher Viskosität verwendet wird. Ein derartiger Kleber hoher Viskosität lässt sich entsprechend in die Abstände bzw. Freiräume zwischen miteinander zu verbindenden Elementen einer Leiterplatte einbringen und verhindert insbesondere ein Rinnen bzw. eine übermäßige Verteilung im Bereich der Abstände, selbst unter Berücksichtigung der vergleichsweise geringen Abstände der miteinander zu verbindenden Elemente.

Für eine besonders zuverlässige Aufbringung bzw. Anordnung des Klebers in den Abständen von miteinander zu verbindenden Elementen wird darüber hinaus vorgeschlagen, dass der Kleber mittels Ausgabevorrichtung bzw. Dispenser, Schablonendruck, Siebdruck oder dgl. aufgebracht wird, wie dies einer weiters bevorzugten Ausführungsform des erfindungsgemäßen Verfahrens entspricht.

Um ein Verteilen des Klebers insbesondere unterhalb von miteinander zu verbindenden Elementen zu vermeiden, wird gemäß einer weiters bevorzugten Ausführungsform vorgeschlagen, dass der Kleber lediglich über einen Teilbereich der Höhenerstreckung von Seitenkanten der miteinander zu verbindenden Umfangsbereiche eingebracht bzw. angeordnet wird. Insbesondere durch Wahl der entsprechenden Viskosität eines Klebers und unter Berücksichtigung des vergleichsweise geringen Abstands zwischen benachbarten und miteinander zu verbindenden Umfangsbereichen der miteinander zu verbindenden Elemente lässt sich sicherstellen, dass ein Ausfüllen und Durchtreten des Klebers über die gesamte Höhenerstreckung des Spalts bzw. Abstands zwischen miteinander zu verbindenden Elementen verhindert wird.

Für eine insbesondere provisorische Positionierung beispielsweise bei Vorliegen einer Mehrzahl von miteinander zu verbindenden Elementen, wobei beispielsweise ein Aushärten des Klebers nach einer Anordnung einer Vielzahl derartiger Elemente vorgenommen wird, wird gemäß einer weiters bevorzugten Ausführungsform vorgeschlagen, dass eine provisorische Verbindung von miteinander zu verbindenden Umfangsbereichen unter Verwendung eines entfernbaren Klebestreifens bzw. -etiketts ausgebildet wird. Derartige entfernbare Klebestreifen bzw. -etiketten können einfach und zuverlässig positioniert werden und erlauben darüber hinaus selbst nach einer Anordnung von miteinander zu verbindenden Elementen eine zumindest geringfügige Korrektur der jeweiligen gegenseitigen Lage vor einer endgültigen Verbindung.

Insbesondere bei Verwendung einer Trägerschicht bzw. eines Trägerelements wird zur Vermeidung eines Anhaftens bei einem Einbringen von Kleber bei insbesondere unbeabsichtigtem Durchtritt des Klebers durch den gesamten Freiraum zwischen den zueinander gewandten Umfangsbereichen vorgeschlagen, dass unter den miteinander zu verbindenden Umfangsbereichen der miteinander zu verbindenden Elemente ein entfernbares Schutzelement, beispielsweise eine entfernbare Papierschicht angeordnet wird, wie dies einer weiters bevorzugten Ausführungsform des erfindungsgemäßen Verfahrens entspricht. Ein derartiges Schutzelement, insbesondere eine entfernbare Papierschicht lässt sich einfach und zuverlässig zumindest in Bereichen anordnen, in welchen während des Verbindungsvorgangs miteinander zu verbindende Umfangsbereiche angeordnet werden, und lässt sich einfach nach der Fertigstellung der Verbindung wiederum von den miteinander verbundenen Leiterplattenelementen entfernen.

Durch die Bereitstellung eines Abstands zwischen miteinander zu verbindenden Elementen einer Leiterplatte, welcher nicht nur Vorteile im Hinblick auf eine Automatisierung der Positionierung einzelner miteinander zu verbindender Elemente sondern auch eine Vereinfachung der Herstellung derselben ermöglicht, lässt sich entlang des einzuhaltenden Abstands zwischen miteinander zu verbindenden bzw. bereits verbundenen Elementen auch eine gegebenenfalls erforderliche Trennung derselben vornehmen. In diesem Zusammenhang wird gemäß einer weiters bevorzugten Ausführungsform vorgeschlagen, dass miteinander verbundene Elemente einer Leiterplatte beispielsweise zu Reparaturzwecken, insbesondere unter Einsatz eines Fräsers oder Lasers, entlang der miteinander verbundenen Umfangsbereiche voneinander getrennt werden. Derart können beispielsweise kostspielige Elemente einer Leiterplatte bei einer Beschädigung aus einer derartigen Leiterplatte entfernt werden und durch neue Elemente ersetzt werden, so dass nicht Leiterplatten bei einer lokalisierbaren Beschädigung lediglich eines Teilbereichs vollständig ersetzt werden müssen.

Während im wesentlichen geradlinige Umfangsbereiche von miteinander zu verbindenden Leiterplattenelementen durch die erfindungsgemäß vorgeschlagene mechanische Verbindung, insbesondere Verklebung zuverlässig verbunden werden können, wird insbesondere für einen wechselseitigen Eingriff von Teilbereichen des miteinander zu verbindenden Umfangs einzelner Elemente gemäß einer weiters bevorzugten Ausführungsform vorgeschlagen, dass miteinander zu verbindende Elemente an miteinander zu verbindenden Umfangsbereichen jeweils in an sich bekannter Weise mit wenigstens einem zueinander komplementären Kopplungselement ausgebildet werden. Derartige komplementäre Kopplungselemente können ebenfalls unter Berücksichtigung des zwischen miteinander zu verbindenden Elementen einzuhaltenden Abstands mit entsprechenden großen Produktionstoleranzen vereinfacht hergestellt werden und erlauben ebenfalls eine im wesentlichen automatisierte Einpassung von miteinander zu verbindenden Elementen, wobei über die komplementären Kopplungselemente die Positionierung erleichtert und die mechanische Festigkeit der Verbindung verbessert werden kann.

In diesem Zusammenhang wird gemäß einer weiters bevorzugten Ausführungsform vorgeschlagen, dass das wenigstens eine Kopplungselement eines miteinander zu verbindenden Elements von einem profilierten, von dem Umfangsbereich des Elements vorragenden Kopplungselement gebildet wird, welches in einer komplementären Ausnehmung des damit zu verbindenden Elements unter Einhaltung des Abstands aufgenommen wird. Derart lässt sich durch Vorsehen entsprechender Kopplungselemente insbesondere die mechanische Stabilität der Verbindung der miteinander zu verbindenden Elemente weiter verbessern bzw. erhöhen.

Insbesondere bei Anordnung bzw. Vorsehen von Rahmen- bzw. Trägerelementen zur Aufnahme bzw. Halterung von Elementen einer Leiterplatte, welche beispielsweise aus einem kostengünstigeren Material hergestellt und für Be- bzw. Verarbeitungszwecke verwendet werden können, wird gemäß einer weiters bevorzugten Ausführungsform vorgeschlagen, dass ein im wesentlichen rechteckiges Element einer Leiterplatte an jeweils einander gegenüberliegenden Umfangsbereichen mit jeweils wenigstens einem Kopplungselement versehen wird, welches mit jeweils einem Kopplungselement eines damit zusammenwirkenden Rahmen- bzw. Trägerelements verbunden wird.

Wie bereits oben erwähnt, ist es möglich, mehrere zur Herstellung einer Leiterplatte zu verwendende und miteinander zu verbindende Elemente beispielsweise in unterschiedlichen Herstellungsschritten und beispielsweise mit unterschiedlichem konstruktiven Aufwand herzustellen, so dass erfindungsgemäß darüber hinaus bevorzugt vorgeschlagen wird, dass eine Mehrzahl von Elementen einer Leiterplatte voneinander beabstandet miteinander verbunden wird.

Zur Lösung der eingangs genannten Aufgaben ist eine aus einer Mehrzahl von miteinander verbundenen Elementen bestehende Leiterplatte im wesentlichen dadurch gekennzeichnet, dass der Abstand zwischen den zueinander gewandten und miteinander zu verbindenden Umfangsbereichen mit maximal 500 µm, insbesondere maximal 200 µm gewählt ist. Wie oben ausgeführt, gelingt somit unter Einhaltung von entsprechend großen Produktionstoleranzen für die miteinander zu verbindenden Elemente günstigerweise auch eine Automatisierung bei der Herstellung derartiger, aus wenigstens zwei Elementen bestehenden Leiterplatten. Für eine ordnungsgemäße mechanische Verbindung unter Einhaltung der Anforderungen beispielsweise im Hinblick auf eine Miniaturisierung derartiger Leiterplatten wird hierbei erfindungsgemäß vorgeschlagen, dass der Abstand zwischen den zueinander gewandten und miteinander zu verbindenden Umfangsbereichen mit maximal 500 µm, insbesondere maximal 200 µm gewählt ist.

Für eine ordnungsgemäße wechselseitige Positionierung einzelner miteinander zu verbindender Elemente wird darüber hinaus vorgeschlagen, dass miteinander zu verbindende Elemente unter Bezugnahme auf wenigstens ein an einem der miteinander zu verbindenden Elemente angeordnetes Ausricht- bzw. Registrierungselement angeordnet und miteinander verbunden sind, wie dies einer weiters bevorzugten Ausführungsform der erfindungsgemäßen Leiterplatte entspricht.

Für eine zuverlässige und einfache Verbindung wird darüber hinaus bevorzugt vorgeschlagen, dass zum Verkleben ein thermisch oder chemisch oder mittels UV-Licht oder IR-Licht aushärtender Kleber verwendet ist, wobei derartige aushärtende Kleber im Rahmen der Herstellung von Leiterplatten an sich bekannt sind.

Für eine zuverlässige Verbindung wird darüber hinaus vorgeschlagen, dass der Kleber lediglich über einen Teilbereich der Höhenerstreckung von Seitenkanten der miteinander zu verbindenden Umfangsbereiche eingebracht bzw. angeordnet ist, wie dies einer weiters bevorzugten Ausführungsform der erfindungsgemäßen Leiterplatte entspricht.

Für eine gegebenenfalls erforderliche Trennung insbesondere bei Feststellung einer Beschädigung eines Teilbereichs einer erfindungsgemäßen Leiterplatte wird darüber hinaus vorgeschlagen, daß miteinander verbundene Elemente einer Leiterplatte beispielsweise zu Reparaturzwecken, insbesondere unter Einsatz eines Fräsers oder Lasers entlang der miteinander verbundenen Umfangsbereiche voneinander trennbar sind, wie dies einer weiters bevorzugten Ausführungsform der Erfindung entspricht.

Für eine einfache Positionierung und mechanisch stabile Kopplung bzw. Verbindung miteinander zu verbindender Elemente wird darüber hinaus bevorzugt vorgeschlagen, daß miteinander zu verbindende Elemente an miteinander zu verbindenden Umfangsbereichen in an sich bekannter Weise jeweils mit wenigstens einem zueinander komplementären Kopplungselement ausgebildet sind, wobei in diesem Zusammenhang gemäß einer weiters bevorzugten Ausführungsform bevorzugt vorgeschlagen wird, daß das wenigstens eine Kopplungselement eines miteinander zu verbindenden Elements von einem profilierten, von dem Umfangsbereich des Elements vorragenden Kopplungselement gebildet ist, welches in einer komplementären Ausnehmung des damit zu verbindenden Elements unter Einhaltung des Abstands aufgenommen ist.

Darüber hinaus wird die Verwendung des erfindungsgemäßen Verfahrens zur Herstellung einer mehrteiligen Leiterplatte unter Erfüllung der oben genannten Aufgaben vorgeschlagen.

Die Erfindung wird nachfolgend anhand von in der beiliegenden Zeichnung schematisch dargestellten Ausführungsbeispielen näher erläutert. In dieser zeigen:
Fig. 1 schematische Draufsichten auf unterschiedliche Ausführungsformen von miteinander verbundenen Elementen einer erfindungsgemäßen Leiterplatte unter Verwendung des erfindungsgemäßen Verfahrens, wobei in Fig. 1a ein Element einer Leiterplatte ein weiteres Element teilweise umgreift, bei der Ausführungsform gemäß
Fig. 1b ein Element einer Leiterplatte vollständig von einem weiteren Element umgriffen ist, bei der Ausführungsform gemäß Fig. 1c mehrere Leiterplattenelemente von einem gemeinsamen Element umgriffen bzw. umgeben sind und bei der Ausführungsform gemäß Fig. 1d mehrere Leiterplattenelemente an einander gegenüberliegenden Rändern bzw. Kanten mit jeweils einem Rahmen- bzw. Trägerelement verbunden sind bzw. werden;
Fig. 2 in vergrößertem Maßstab schematische Ansichten von unterschiedlichen Ausbildungen von Kopplungselementen zwischen miteinander zu verbindenden Elementen einer Leiterplatte;
Fig. 3 schematisch den Verfahrensablauf einer Verbindung von miteinander zu verbindenden Elementen einer Leiterplatte, wobei in Fig. 3a die Anordnung von miteinander zu verbindenden Elementen nebeneinander, in Fig. 3b das Aufbringen eines Klebers zur Verbindung der miteinander zu verbindenden Elemente und in Fig. 3c der Zustand dargestellt ist, nachdem der Kleber aufgetragen wurde;
Fig. 4 in einer schematischen Draufsicht die relative Anordnung einer Mehrzahl von Elementen einer Leiterplatte zueinander unter Bezugnahme auf wenigstens ein Ausricht- bzw. Registrierelement;
Fig. 5 eine schematische Draufsicht auf ein Trägerelement zur Anordnung einer Mehrzahl von miteinander zu verbindenden Elementen einer Leiterplatte, wobei zur provisorischen Festlegung ein Unterdruck bzw. Vakuum erzeugt bzw. angelegt wird;
Fig. 6 eine schematische Darstellung einer abgewandelten Ausführungsform einer Anordnung einer Mehrzahl von Elementen auf einem Trägerelement, wobei Fig. 6a einen schematischen teilweisen Schnitt darstellt und Fig. 6b eine schematische Draufsicht zeigt;
Fig. 7 eine schematische Ansicht einer Ausbildung einer provisorischen Festlegung von zwei miteinander zu verbindenden Elementen unter Verwendung eines Klebestreifens; und
Fig. 8 schematisch den Verfahrensablauf einer Verbindung und nachfolgenden Trennung von zwei Elementen beispielsweise zu Reparaturzwecken und für einen Ersatz von einem von derart miteinander verbundenen Elementen.

Zu den Figuren wird einleitend angemerkt, daß teilweise lediglich ein Teilbereich von Elementen einer herzustellenden Leiterplatte im Bereich einer Festlegung von aneinander festzulegenden bzw. miteinander zu verbindenden Elementen dargestellt ist. Weiters sind die gegenseitigen Abmessungen insbesondere im Hinblick auf einen zwischen den einzelnen Elementen vorzusehenden Abstand nicht maßstabsgemäß dargestellt. Darüber hinaus ist zur Vereinfachung der Darstellung auf den einzelnen Elementen einer herzustellenden Leiterplatte keinerlei Strukturierung angedeutet und es sind keinerlei gegebenenfalls festgelegte bzw. aufzunehmende Bauteile dargestellt.

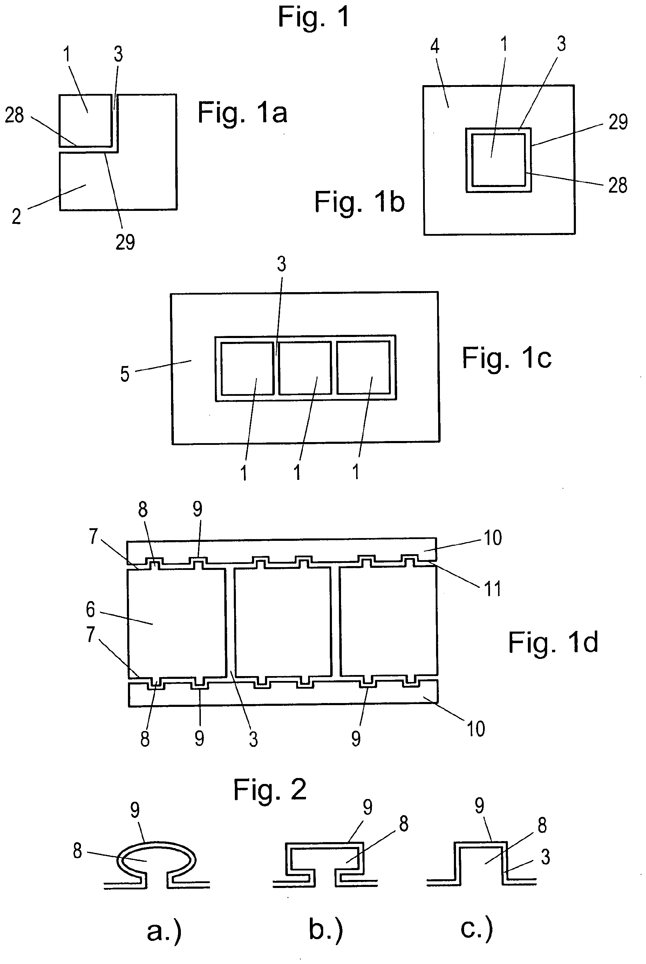

In der Darstellung gemäß Fig. 1 sind unterschiedliche Möglichkeiten einer Verbindung von miteinander zu verbindenden Elementen einer Leiterplatte schematisch angedeutet, wobei die dargestellten Möglichkeiten lediglich Ausführungsbeispiele zeigen und keineswegs beschränkend auszulegen sind.

Bei der Ausführungsform gemäß Fig. 1a wird, wie dies nachfolgend noch im Detail erörtert werden wird, ein im wesentlichen rechteckiges bzw. quadratisches Element 1 an zwei Umfangsseiten von einem damit zu verbindenden Element 2 umgeben, wobei zwischen den miteinander zu verbindenden Elementen 1 und 2 ein Abstand bzw. Spalt 3 angedeutet ist. Zueinander gewandte Umfangsbereiche der Elemente 1 und 2 sind mit 28 und 29 bezeichnet.

Bei der Ausführungsform gemäß Fig. 1b wird ein wiederum im wesentlichen quadratisches Element 1 von einem ebenfalls im wesentlichen quadratischen Element 4 umgeben, wobei beispielsweise das quadratische Element 1 im wesentlichen wiederum unter Einhaltung eines Abstands bzw. Spalts 3 an im wesentlichen sämtlichen Umfangsseiten aufgenommen wird.

Bei der Ausführungsform gemäß Fig. 1c wird in einem gemeinsamen Element 5 eine Mehrzahl von wiederum schematisch mit 1 angedeuteten Elementen aufgenommen, wobei zwischen den einzelnen Elementen 1 wiederum ein Abstand bzw. Spalt 3 vorgesehen ist.

Die in den Fig. 1a bis 1c dargestellten, unterschiedlichen Elemente 1, 2, 4 und 5 einer Leiterplatte können beispielsweise in unterschiedlichen Herstellungsverfahren einer insbesondere mehrlagigen Leiterplatte hergestellt werden und nach ihrer Fertigstellung, wie dies nachfolgend im Detail erörtert werden wird, zur Bereitstellung einer fertiggestellten Leiterplatte, welche aus unterschiedlichen Teilbereichen bzw. Elementen besteht, miteinander verbunden bzw. gekoppelt werden.

Bei der Ausführungsform gemäß Fig. 1d ist angedeutet, daß eine Mehrzahl von Elementen 6 an jeweils einander gegenüberliegenden Umfangsbereichen bzw. Seitenrändern 7 jeweils mit schematisch mit 8 bezeichneten Kopplungselementen versehen ist, wobei die Kopplungselemente 8 mit komplementären Kopplungselementen 9 an Rahmen- bzw. Trägerelementen 10 zusammenwirken und verbunden werden. Auch bei der Ausführungsform gemäß Fig. 1d ist ersichtlich, daß im Bereich der Kopplungselemente 8 und 9 als auch des anschließenden Umfangsbereichs 7 der Elemente 6 sowie des Umfangsbereichs 11 der Rahmenelemente 10 jeweils ein Abstand bzw. Spalt 3 vorgesehen bzw. beibehalten wird.

In Fig. 2 sind schematisch unterschiedliche Ausführungsformen von Kopplungselementen gezeigt, welche unabhängig von ihrer geometrischen Form der Einfachheit halber wiederum mit 8 bezeichnet sind, welche mit komplementären Ausnehmungen 9 zusammenwirken. Wie aus der Darstellung gemäß Fig. 2 ersichtlich, ist im Bereich der miteinander zusammenwirkenden Kopplungselemente 8 und 9 jeweils wiederum ein Abstand bzw. Spalt 3 vorgesehen.

Während bei der Darstellung gemäß Fig. 1 Kopplungselemente 8 und 9 lediglich bei der Ausführungsform gemäß Fig. 1d angedeutet sind, ist festzuhalten, daß derartige Kopplungselemente 8 und 9 von miteinander zu verbindenden Elementen, wie sie beispielsweise in Fig. 2 angedeutet sind, auch bei in Fig. 1a bis 1c dargestellten Ausführungsformen jeweils an den Umfangsbereichen 28 und 29 zum Einsatz gelangen können.

Darüber hinaus sind die in Fig. 2 lediglich beispielhaft dargestellten Ausführungsformen von Kopplungselementen 8 und komplementären Ausnehmungen 9 nicht beschränkend auszulegen.

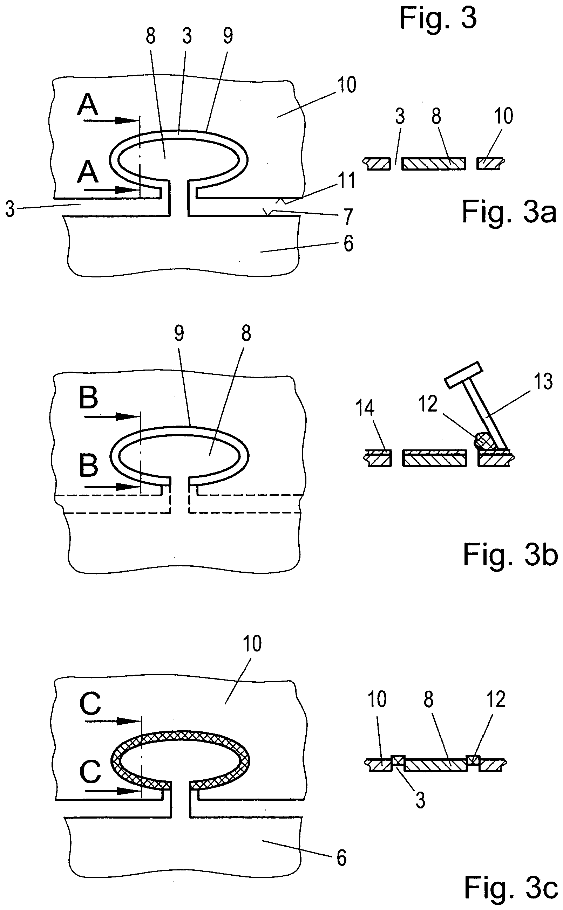

Ein Verbindungsvorgang von zwei miteinander zu verbindenden Elementen wird in größerem Detail anhand der Darstellung von Fig. 3 nachfolgend näher erläutert, wobei beispielsweise für eine Ausbildung, wie sie in Fig. 1d unter Verwendung von Kopplungselementen 8 und 9 gemäß Fig. 2a dargestellt ist, in Fig. 3 jeweils lediglich ein Teilbereich der miteinander zu verbindenden Elemente gezeigt ist. Weiters ist in Fig. 3a, 3b und 3c jeweils auf der linken Seite der Darstellung eine schematische Draufsicht auf einen derartigen Teilbereich einer Verbindung von miteinander zusammenwirkenden Kopplungselementen 8 und Ausnehmungen 9 angedeutet, während für die einzelnen Verfahrensschritte zusätzlich auf der rechten Seite der Darstellungen ein Schnitt entlang den Linien A-A, B-B und C-C angedeutet ist.

Bei dem in Fig. 3a dargestellten Verfahrensschritt ist ersichtlich, daß miteinander zu verbindende Elemente, welche entsprechend der Darstellung gemäß Fig. 1d wiederum mit 6 und 10 bezeichnet sind, im Bereich ihrer zueinander komplementären Kopplungselemente und Ausnehmungen 8 und 9 relativ zueinander derart positioniert werden, daß im wesentlichen über den gesamten Umfang der Kopplungselemente 8 und 9 sowie im Bereich der zueinander gewandten Umfangsbereiche 7 und 11 jeweils ein Abstand 3 eingehalten wird, in welchen nachfolgend ein Kleber eingebracht wird.

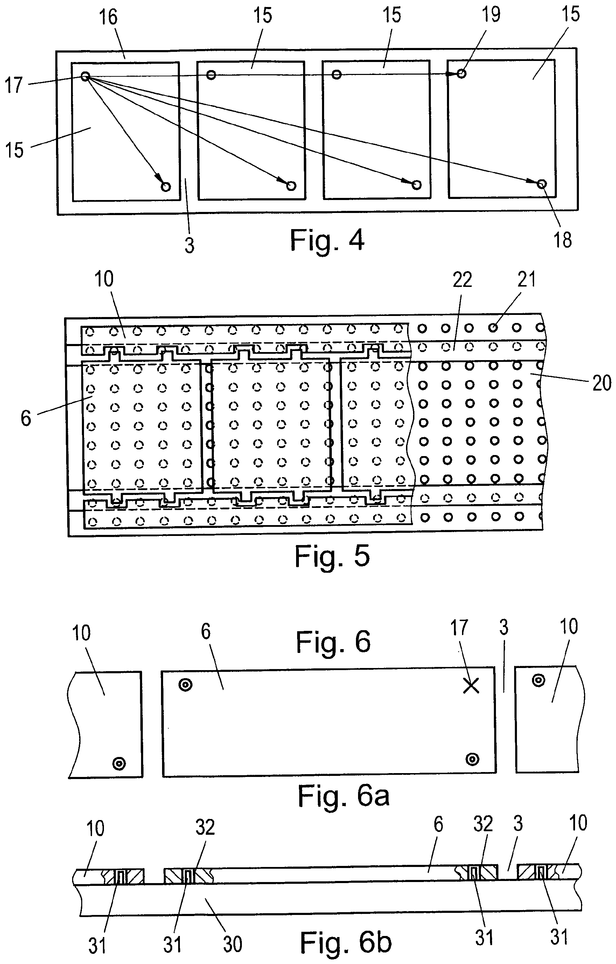

Der Abstand 3 wird derart gewählt, daß er eine maximale Breite von 500 µm, günstigerweise 200 µm aufweist, so daß mit großen Produktionstoleranzen die miteinander zu verbindenden Elemente, welche gegebenenfalls zusätzliche Kopplungselemente 8 und 9 aufweisen, hergestellt werden können. Eine Einhaltung eines derartigen Abstands von beispielsweise maximal 200 µm erlaubt darüber hinaus, wie dies insbesondere unter Bezugnahme auf Fig. 4 noch in größerem Detail dargestellt werden wird, auch eine Anordnung einer Mehrzahl von Elementen, welche gegebenenfalls eine Mehrzahl von Leiterplatten ausbilden, auf einem gemeinsamen Trägerelement, welches für eine weitere Bearbeitung, beispielsweise Bestückung herangezogen werden kann, wobei Toleranzen einer relativen Ausrichtung zwischen einer derartigen Vielzahl von anzuordnenden Elementen von ± 50 µm, insbesondere ± 30 µm erzielbar sind bzw. eingehalten werden können. Durch Vorsehen eines Abstands von maximal 200 µm, in welchen nachfolgend ein Kleber eingebracht wird, läßt sich auch eine Automatisierung beim Zusammenstellen und Verbinden von derart miteinander zu verbindenden Elementen einer Leiterplatte erzielen, so daß auf aufwendige Einpaßvorgänge von Elementen, welche insbesondere manuell durchgeführt werden müssen, verzichtet werden kann.

Nach dem Anordnen der miteinander zu verbindenden Elemente in einer räumlichen Nahebeziehung zueinander, wie dies in Fig. 3a dargestellt ist, erfolgt beim Verfahrensschritt gemäß Fig. 3b ein Aufbringen eines Klebers 12 beispielsweise mit einer Rakel 13 unter Verwendung einer Schablone 14, so daß nach dem Aufbringen des Klebers 12 und einer Entfernung der Schablone 14, wie dies im Verfahrensschritt gemäß Fig. 3c dargestellt ist, der Kleber 12 in den Spalt 13 zur Verbindung der miteinander zu verbindenden Elemente 6 und 10 eingebracht wurde.

Wie aus der Darstellung gemäß Fig. 3c ersichtlich, wird hiebei der Kleber 12, welcher eine hohe Viskosität aufweist, günstiger Weise lediglich über einen Teilbereich der Höhenerstreckung des Spalts 3 eingebracht, so daß insbesondere bei einem Abstützen der miteinander zu verbindenden Elemente 6 und 10, wie dies nachfolgend unter Bezugnahme auf Fig. 5 im Detail erörtert werden wird, ein Durchtreten des Klebers 12 zur Unterseite der Elemente 6 und 10 somit ein Anhaften der Elemente an einem Trägerelement vermieden werden kann. Weiters ist aus der Darstellung gemäß Fig. 3c ersichtlich, daß insbesondere in Abhängigkeit von der Dicke der verwendeten Schablone 14 der Kleber 12 nur geringfügig über die Oberfläche der Elemente 6 und 10 vorragt, so daß insbesondere nachfolgende Bearbeitungsschritte nicht behindert oder beeinträchtigt werden.

Nach dem Aufbringen des Klebers, wie dies in Fig. 3c angedeutet ist, folgt beispielsweise ein Härten desselben unter Einsatz von Wärme oder UV-Licht. Bei Einsatz eines thermisch härtenden bzw. aushärtenden Klebers 12 werden beispielsweise die Temperaturen zwischen 80 °C und 200 °C gewählt, um insbesondere eine Beeinträchtigung der bereits fertiggestellten Leiterplattenelemente zu vermeiden.

Zur Vereinfachung weiterer Verfahrensschritte wird darüber hinaus auch eine Anpassung des Ausdehnungskoeffizienten des Klebers 12 an denjenigen der daran anschließenden Elemente 6 bzw. 10 vorgenommen.

Anstelle des in Fig. 3c angedeuteten Schablonendrucks kann der Kleber 12 beispielsweise durch einen Siebdruck oder auch durch ein Ausbringen im Bereich der zueinander gewandten Umfangsbereiche 7 und 11 der miteinander zu verbindenden Elemente 6 und 10 aufgebracht werden.

Bei der Darstellung gemäß Fig. 3 ist darüber hinaus ersichtlich, daß im wesentlichen eine Anordnung des Klebers 12 und somit eine mechanische Verbindung zwischen den miteinander zu verbindenden Elementen lediglich im Bereich der Kopplungselemente 8 und 9 vorgesehen ist. Alternativ kann insbesondere zur Erhöhung der Festigkeit der Verbindung der miteinander zu verbindenden Elemente 6 und 10 im wesentlichen eine vollflächige Verbindung über die gesamten Umfangsbereiche 7 und 11 der miteinander zu verbindenden Elemente 6 und 10 vorgesehen sein.

Durch ein derartiges Verfahren wird es beispielsweise möglich, insbesondere unter Erhöhung bzw. Verbesserung der Festigkeit einer Verbindung zwischen benachbarten Elementen 6 und 10 durch Unterstützung der Kopplungselemente 8 und 9 eine Belastbarkeit von beispielsweise 2 kg zur Verfügung zu stellen, wobei dies für eine weitere Verwendung bzw. Bearbeitung derartiger Leiterplatten ausreichend ist. Darüber hinaus wird gewährleistet, daß auch beispielsweise in nachfolgenden Be- bzw. Verarbeitungsschritten, wie beispielsweise Reflow- bzw. Lötprozessen, beispielsweise zum Fixieren von Bauelementen keine Veränderungen an der hergestellten mechanischen Verbindung zwischen den miteinander zu verbindenden Elementen 6 und 10 auftreten.

In Fig. 4 ist schematisch angedeutet, daß bei einer Positionierung einer Vielzahl von Elementen 15 in einem gemeinsamen Element 16 insbesondere ausgehend von einem beispielsweise von einer Bohrung bzw. Durchbrechung gebildeten Ausricht- bzw. Registrierelement 17 jeweils unter Einhaltung des Abstands 3 von beispielsweise maximal 200 µm eine Ausrichtung derartiger benachbarter Elemente 15 unter Einhaltung einer Toleranz von ± 50 µm, insbesondere ± 30 µm unter Bezugnahme auf an den einzelnen Elementen 15 zusätzlich vorgesehenen Ausrichtelementen 18 und 19 erzielbar ist. Eine Einhaltung derart geringer Toleranzen einer relativen Ausrichtung ist insbesondere für nachfolgende Be- bzw. Verarbeitungsvorgänge, wie beispielsweise Bestückungsprozesse günstig bzw. erforderlich, um ebenfalls insbesondere automatisiert nicht näher dargestellte Komponenten an derartigen Elementen 15 festzulegen.

Bei der schematischen Darstellung gemäß Fig. 5 ist ersichtlich, daß auf einem schematisch mit 20 bezeichneten Trägerelement, welches mit einer Vielzahl von Öffnungen bzw. Durchbrechungen 21 zur Ausbildung bzw. Anlegung eines Unterdrucks bzw. Vakuums durch Anlegen einer nicht näher gezeigten Unterdruckquelle ausgebildet ist, eine Mehrzahl von jeweils miteinander zu verbindenden Elementen angeordnet wird, welche gemäß der Ausführungsform von Fig. 1d wiederum mit 6 und 10 bezeichnet sind.

Um einen Durchtritt eines Klebers im Bereich der Verbindung der miteinander zu verbindenden Elemente und somit ein Anhaften an dem Trägerelement 20 zu verhindern, ist darüber hinaus in Fig. 5 angedeutet, daß im Bereich der Klebestellen eine Schutzschicht, beispielsweise eine entfernbare Papierschicht 22 angeordnet wird, welche nach einem Verbinden der miteinander zu verbindenden Elemente 6 und 10 selbst bei einem Durchtritt des Klebers über die gesamte Höhenerstreckung der miteinander zu verbindenden Umfangsbereiche in einfacher Weise wiederum entfernt werden kann, wodurch ein Anhaften an dem Trägerelement 20 und insbesondere ein Verschmutzen desselben mit Kleber verhindert wird.

Bei der Ausführungsform gemäß Fig. 6 ist ein Trägerelement mit 30 bezeichnet, wobei von dem Trägerelement 30 Erhebungen bzw. Stifte 31 vorragen, welche für eine zumindest provisorische Sicherung von miteinander zu verbindenden Elementen in einem wiederum mit 6 bezeichneten Element durch schematisch angedeutete Öffnungen bzw. Durchbrechungen 32 eintreten. Mit dem Element 6, welches durch ein Zusammenwirken der Stifte bzw. Erhebungen 31 und der Öffnungen 32 provisorisch auf dem Trägerelement 30 gesichert ist, werden in weiterer Folge wiederum mit 10 bezeichnete Elemente, insbesondere Rahmen- bzw. Trägerelemente verbunden, welche ebenfalls über schematisch mit 31 angedeutete Stifte in ihrer relativen Positionierung zu dem damit zu verbindenden Element 6 auf dem Trägerelement 30 gesichert sind, welches der Übersichtlichkeit halber in Fig. 6b nicht dargestellt ist. Zur Positionierung bzw. Ausrichtung ist ein wiederum mit 17 bezeichnetes Ausricht- bzw. Registrierelement angedeutet.

In dem wiederum mit 3 bezeichneten Spalt zwischen den Elementen 6 bzw. 10 wird, wie dies im Zusammenhang mit vorangehenden Ausführungsformen beschrieben wurde, wiederum ein Kleber zur Verbindung der Elemente 6 und 10 eingebracht.

Bei der Darstellung gemäß Fig. 6 sind darüber hinaus die beispielsweise in vorangehenden Figuren zur Verbindung von Elementen 6 und 10 ergänzend vorgesehenen Kopplungselemente nicht dargestellt bzw. können weggelassen werden.

Anstelle und/oder zusätzlich zu dem in Fig. 5 gezeigten Halten bzw. Sichern der miteinander zu verbindenden Elemente durch Anlegen eines Unterdrucks sowie durch die Positionierstifte 31 und die entsprechenden Öffnungen bzw. Durchbrechungen 32 zur Aufnahme derselben gemäß Fig. 6 kann eine provisorische Sicherung an dem Trägerelement 20 bzw. 30 auch beispielsweise durch ein Klemmen der einzelnen Elemente an dem Trägerelement bis zu einem Aufbringen und insbesondere Aushärten des Klebers vorgesehen sein, welcher in den Abstand bzw. Spalt 3 zwischen miteinander zu verbindenden Elementen 6 bzw. 10 einzubringen ist.

Darüber hinaus oder alternativ kann für eine Sicherung einer Positionierung der miteinander zu verbindenden Elemente 6 bzw. 10 die zu den miteinander zu verbindenden Elementen 6 bzw. 10 gerichtete Oberfläche des Trägerelements 20 bzw. 30 aus einem rutschfesten Material, wie beispielsweise Silikon, Gummi oder dgl. gebildet sein oder mit einem derartigen Material beschichtet sein. Derart kann insbesondere ohne zusätzliches Vorsehen eines Anlegens eines Unterdrucks, wie dies in Fig. 5 angedeutet ist, oder Vorsehen von zusätzlichen Positionierstiften 31 und entsprechende Ausnehmungen bzw. Durchbrechungen 32, wie dies in Fig. 6 angedeutet ist, eine zumindest provisorische Sicherung und Positionierung der miteinander zu verbindenden Elemente 6 und 10 zur Verfügung gestellt werden.

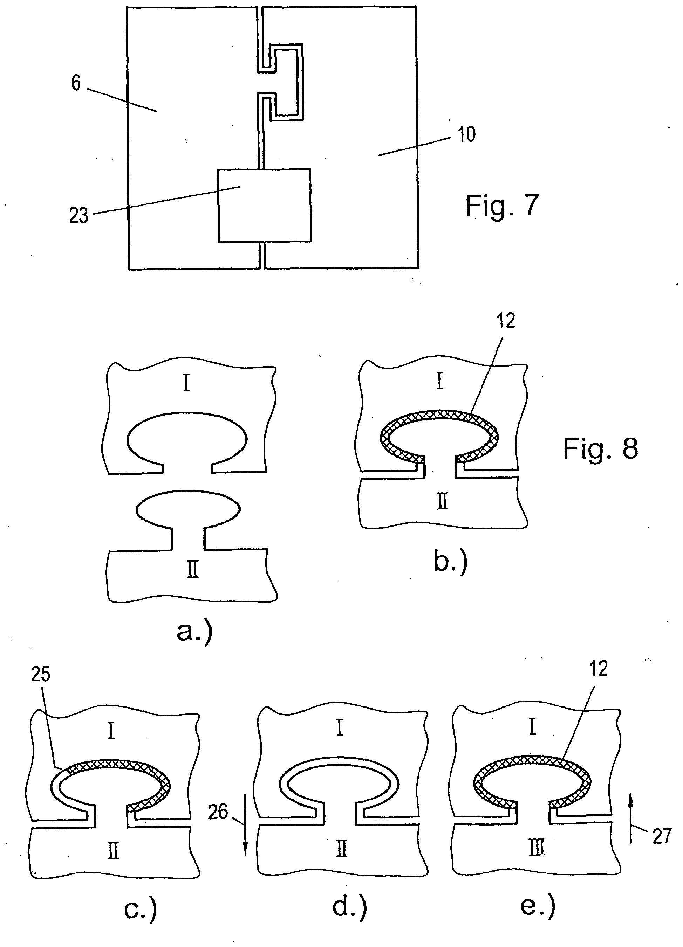

Bei der Darstellung gemäß Fig. 7 ist schematisch angedeutet, daß wiederum mit 6 und 10 bezeichnete, miteinander zu verbindende Elemente provisorisch über einen Klebestreifen bzw. ein Klebeetikett 23 aneinander gesichert werden, wobei dieser Klebestreifen 23 nach einem Verbinden der Elemente 6 und 10 wiederum entfernt werden kann.

Aufgrund des vorgesehenen Abstands bzw. Spalts 3 zwischen miteinander zu verbindenden Elemente einer Leiterplatte, welcher nicht nur eine Vereinfachung der Herstellung sowie eine Automatisierung beim Zusammenfügen und Verbinden derselben ermöglicht, wird es auch möglich, beispielsweise schadhafte und gegebenenfalls mit kostspieligen Bauteilen bestückte Elemente einer Leiterplatte insbesondere entlang der Verbindungsstelle bzw. -linie voneinander zu trennen und insbesondere kostspielige Elemente einer Leiterplatte entsprechend zu ersetzen.

In Fig. 8 ist ein derartiger Austausch- bzw. Reparaturvorgang schematisch angedeutet.

Ausgehend von zwei Leiterplattenelementen I und II gemäß Fig. 8a, welche gemäß Fig. 8b miteinander verbunden werden, wie dies beispielsweise in Fig. 3 im Detail dargestellt ist, erfolgt bei dem Verfahrensschritt gemäß Fig. 8c ein Trennen der miteinander verbundenen Leiterplattenelemente I und II entlang der Verbindungsstelle 25 beispielsweise mit einem Fräser oder einem Laser.

Nach einer in Fig. 8c dargestellten Trennung entlang der Kopplungselemente 8 und 9 kann das defekte Element II von dem Element I gelöst werden, wie dies durch einen Pfeil 26 in Fig. 8d angedeutet ist, wonach entsprechend dem Pfeil 27 in Fig. 8e ein neues Element III eingesetzt und über eine wiederum mit 12 bezeichnete Verklebung mit dem Element I verbunden wird.

Es lassen sich somit einfach und mit großen Bearbeitungstoleranzen herzustellende Elemente einer Leiterplatte sicher und zuverlässig und bei verringertem Arbeitsaufwand und insbesondere mit der Möglichkeit einer Automatisierung des Anordnungs- und Verbindungsvorgangs miteinander verbinden.

## Patentansprüche

1. Verfahren zum Verbinden einer Mehrzahl von Elementen einer Leiterplatte, umfassend die folgenden Schritte:
- Bereitstellen der miteinander zu verbindenden Elemente (1, 2, 4, 5, 6, 10, 15, 16, I, II, III) einer Leiterplatte mit aufeinander abgestimmten Konturen,
- Anordnen der miteinander zu verbindenden Elemente (1, 2, 4, 5, 6, 10, 15, 16, I, II, III) in einer räumlichen Nahebeziehung an wenigstens einem Umfangsbereich (7, 11, 28, 29) mit zueinander komplementären Kontur unter Einhaltung eines Abstands (3) zwischen den zueinander gewandten Umfangsbereichen (7, 11, 28, 29), und
- mechanisches Verbinden durch Verkleben der zueinander gewandten Umfangsbereiche (7, 11, 28, 29) über wenigstens einen Teilbereich derselben zur Verbindung der miteinander zu verbindenden Elemente (1, 2, 4, 5, 6, 10, 15, 16, I, II, III) der Leiterplatte, wobei die miteinander zu verbindenden Elemente (6, 10) einer Leiterplatte zur Durchführung des Verbindungsvorgangs auf einem Trägerelement (20, 30) angeordnet bzw. abgestützt werden, die miteinander zu verbindenden Leiterplattenelemente (6, 10) während des Verbindungsvorgangs an dem Trägerelement (20, 30) durch Anlegen eines Vakuums, durch ein Klemmen, durch ein Eintreten von von dem Trägerelement (30) vorragenden Erhebungen bzw. Stiften (31) in komplementäre Ausnehmungen (32) der Elemente (6, 10) gesichert gehalten werden und/oder die zu den abzustützenden Elementen (6, 10) gerichtete Oberfläche des Trägerelements (20, 30) aus einem ein Verrutschen verhindernden Material, beispielsweise Silikon, Gummi oder dgl., gebildet bzw. damit beschichtet ist, **dadurch gekennzeichnet, dass** der Abstand (3) zwischen den zueinander gewandten und miteinander zu verbindenden Umfangsbereichen (7, 11, 28, 29) mit maximal 500 µm, insbesondere maximal 200 µm gewählt wird.

2. Verfahren nach Anspruch 1, **dadurch gekennzeichnet, dass** miteinander zu verbindende Elemente (15, 16) unter Bezugnahme auf wenigstens ein an einem der miteinander zu verbindenden Elemente angeordnetes Ausricht- bzw. Registrierungselement (17) angeordnet und miteinander verbunden werden.

3. Verfahren nach Anspruch 1 oder 2, **dadurch gekennzeichnet, dass** zum Verkleben ein thermisch oder chemisch oder mittels UV-Licht oder IR-Licht aushärtender Kleber (12) verwendet wird.

4. Verfahren nach Anspruch 3, **dadurch gekennzeichnet, dass** ein thermisches Aushärten des Klebers (12) bei einer Temperatur zwischen 80 °C und 300 °C vorgenommen wird.

5. Verfahren nach Anspruch 4, **dadurch gekennzeichnet, dass** ein Kleber (12) hoher Viskosität verwendet wird.

6. Verfahren nach einem der Ansprüche 1 bis 5, **dadurch gekennzeichnet, dass** der Kleber (12) mittels Ausgabevorrichtung, Schablonendruck, Siebdruck oder dgl. aufgebracht wird.

7. Verfahren nach einem der Ansprüche 3 bis 6, **dadurch gekennzeichnet, dass** der Kleber (12) lediglich über einen Teilbereich der Höhenerstreckung von Seitenkanten der miteinander zu verbindenden Umfangsbereiche (7, 11, 28, 29) eingebracht bzw. angeordnet wird.

8. Verfahren nach einem der Ansprüche 1 bis 7, **dadurch gekennzeichnet, dass** eine provisorische Verbindung von miteinander zu verbindenden Umfangsbereichen (7, 11, 28, 29) unter Verwendung eines entfernbaren Klebestreifens bzw. -etiketts (23) ausgebildet wird.

9. Verfahren nach einem der Ansprüche 1 bis 8, **dadurch gekennzeichnet, dass** unter den miteinander zu verbindenden Umfangsbereichen der miteinander zu verbindenden Elemente (6, 10) ein entfernbares Schutzelement (22), beispielsweise eine entfernbare Papierschicht angeordnet wird.

10. Verfahren nach einem der Ansprüche 1 bis 9, **dadurch gekennzeichnet, dass** miteinander verbundene Elemente (I, II, III) einer Leiterplatte beispielsweise zu Reparaturzwecken, insbesondere unter Einsatz eines Fräsers oder Lasers, entlang der miteinander verbundenen Umfangsbereiche voneinander getrennt werden.

11. Verfahren nach einem der Ansprüche 1 bis 10, **dadurch gekennzeichnet, dass** miteinander zu verbindende Elemente (6, 10) an miteinander zu verbindenden Umfangsbereichen (7, 11) jeweils in an sich bekannter Weise mit wenigstens einem zueinander komplementären Kopplungselement (8, 9) ausgebildet werden.

12. Verfahren nach Anspruch 11, **dadurch gekennzeichnet, dass** das wenigstens eine Kopplungselement (8) eines miteinander zu verbindenden Elements (6) von einem profilierten, von dem Umfangsbereich des Elements vorragenden Kopplungselement gebildet wird, welches in einer komplementären Ausnehmung (9) des damit zu verbindenden Elements (10) unter Einhaltung des Abstands (3) aufgenommen wird.

13. Verfahren nach Anspruch 11 oder 12, **dadurch gekennzeichnet, dass** ein im wesentlichen rechteckiges Element (6) einer Leiterplatte an jeweils einander gegenüberliegenden Umfangsbereichen mit jeweils wenigstens einem Kopplungselement (8) versehen wird, welches mit jeweils einem Kopplungselement (9) eines damit zusammenwirkenden Rahmen- bzw. Trägerelements (10) verbunden wird.

14. Verfahren nach Anspruch 11, 12 oder 13, **dadurch gekennzeichnet, dass** eine Mehrzahl von Elementen (1, 2, 4, 5, 6, 10, 15, 16, I, II, III) einer Leiterplatte voneinander beabstandet miteinander verbunden wird.

15. Leiterplatte, bestehend aus einer Mehrzahl von miteinander verbundenen Elementen, wobei wenigstens zwei miteinander zu verbindende Elemente (1, 2, 4, 5, 6, 10, 15, 16, I, II, III) der Leiterplatte an wenigstens einem Umfangsbereich (7, 11, 28, 29) derselben unter Einhaltung eines Abstands (3) und unter Abstützung auf einem Trägerelement miteinander durch Verklebung mechanisch verbunden sind, **dadurch gekennzeichnet, dass** der Abstand (3) zwischen den zueinander gewandten und miteinander zu verbindenden Umfangsbereichen (7, 11, 28, 29) mit maximal 500 µm, insbesondere maximal 200 µm gewählt ist.

16. Leiterplatte nach Anspruch 15, **dadurch gekennzeichnet, dass** miteinander zu verbindende Elemente (15, 16) unter Bezugnahme auf wenigstens ein an einem der miteinander zu verbindenden Elemente angeordnetes Ausricht- bzw. Registrierungselement (17) angeordnet und miteinander verbunden sind.

17. Leiterplatte nach Anspruch 15 oder 16, **dadurch gekennzeichnet, dass** zum Verkleben ein thermisch oder chemisch oder mittels UV-Licht oder IR-Licht aushärtender Kleber (12) verwendet ist.

18. Leiterplatte nach Anspruch 17, **dadurch gekennzeichnet, dass** der Kleber (12) lediglich über einen Teilbereich der Höhenerstreckung von Seitenkanten der miteinander zu verbindenden Umfangsbereiche (7, 11, 28, 29) eingebracht bzw. angeordnet ist.

19. Leiterplatte nach einem der Ansprüche 15 bis 18, **dadurch gekennzeichnet, dass** miteinander verbundene Elemente (I, II, III) einer Leiterplatte beispielsweise zu Reparaturzwecken, insbesondere unter Einsatz eines Fräsers oder Lasers entlang der miteinander verbundenen Umfangsbereiche voneinander trennbar sind.

20. Leiterplatte nach einem der Ansprüche 15 bis 19, **dadurch gekennzeichnet, dass** miteinander zu verbindende Elemente (6, 10) an miteinander zu verbindenden Umfangsbereichen (7, 11) in an sich bekannter Weise jeweils mit wenigstens einem zueinander komplementären Kopplungselement (8, 9) ausgebildet sind.

21. Leiterplatte nach Anspruch 20, **dadurch gekennzeichnet, dass** das wenigstens eine Kopplungselement (8) eines miteinander zu verbindenden Elements (6) von einem profilierten, von dem Umfangsbereich (7) des Elements vorragenden Kopplungselement gebildet ist, welches in einer komplementären Ausnehmung (9) des damit zu verbindenden Elements (10) unter Einhaltung des Abstands aufgenommen ist.

22. Verwendung des Verfahrens nach einem der Ansprüche 1 bis 14 zur Herstellung einer mehrteiligen Leiterplatte.

## Claims

1. A method for connecting a plurality of elements of a printed circuit board, comprising the steps of
- providing with mutually matching contours the elements to be connected (1, 2, 4, 5, 6, 10, 15, 16, I, II, III) of a printed circuit board,
- arranging with mutually complementary contours in a close spatial relationship on at least one peripheral region (7, 11, 28, 29) the elements to be connected (1, 2, 4, 5, 6, 10, 15, 16, I, II, III), while keeping a distance (3) between the mutually facing peripheral regions (7, 11, 28, 29), and
- mechanically connecting by gluing the mutually facing peripheral regions (7, 11, 28, 29) over at least portions thereof, for connecting the elements to be connected (1, 2, 4, 5, 6, 10, 15, 16, I, II, III) of the printed circuit board, wherein the printed circuit board elements to be connected (6, 10) are arranged or supported on a carrier element (20, 30) for carrying out the connecting procedure, the printed circuit board elements to be connected (6, 10) are kept secured to the carrier element (20, 30) during the connecting procedure by applying a vacuum, by clamping, by elevations or pins (31) projecting from the carrier element (30) entering complementary recesses (32) of the elements (6, 10), and/or the surface of the carrier element (20, 30) facing the elements (6, 10) to be supported is formed by, or coated with, an antiskid material, e.g. silicone, rubber or the like,
**characterized in that** the distance (3) between the mutually facing peripheral regions to be connected (7, 11, 28, 29) is selected to be 500 µm at most and, in particular, 200 µm at most.

2. A method according to claim 1, **characterized in that** elements to be connected (15, 16) are arranged and connected with reference to at least one aligning or registering element (17) provided on one of the elements to be connected.

3. A method according to claim 1 or 2, **characterized in that** a thermally or chemically or UV or IR curable adhesive (12) is used for gluing.

4. A method according to claim 3, **characterized in that** thermal curing of the adhesive (12) is carried out at temperatures between 80°C and 300°C.

5. A method according to claim 4, **characterized in that** a high-viscosity adhesive (12) is used.

6. A method according to any one of claims 1 to 5, **characterized in that** the adhesive (12) is applied by the aid of a dispensing device, template printing, screen printing or the like.

7. A method according to any one of claims 3 to 6, **characterized in that** the adhesive (12) is merely introduced or arranged over a portion of the vertical extension of side edges of the peripheral regions to be connected (7, 11, 28, 29).

8. A method according to any one of claims 1 to 7, **characterized in that** a temporary connection of peripheral regions to be connected (7, 11, 28, 29) is formed by using a removable adhesive tape or label (23).

9. A method according to any one of claims 1 to 8, **characterized in that** a removable protective element (22), for instance a removable sheet of paper, is arranged below the peripheral regions to be connected, of the elements to be connected (6, 10).

10. A method according to any one of claims 1 to 9, **characterized in that** connected elements (I, II, III) of a printed circuit board can be separated along the interconnected peripheral regions, e.g. for repair purposes, particularly by using a cutter or laser.

11. A method according to any one of claims 1 to 10, **characterized in that** elements to be connected (6, 10), in a manner known per se, are each formed with at least one relatively complementary coupling element (8, 9) on peripheral regions to be connected (7, 11).

12. A method according to claim 11, **characterized in that** the at least one coupling element (8) of an element (6) to be connected is formed by a profiled coupling element projecting from the peripheral region of said element and received in a complementary recess (9) of the element (10) to be connected therewith, while keeping said distance (3).

13. A method according to claim 11 or 12, **characterized in that** a substantially rectangular element (6) of a printed circuit board, on respectively opposite peripheral regions, is each provided with at least one coupling element (8) each connected with a coupling element (9) of a frame or carrier element (10) cooperating therewith.

14. A method according to claim 11, 12 or 13, **characterized in that** a plurality of elements (1, 2, 4, 5, 6, 10, 15, 16, I, II, III) of a printed circuit board are connected with one another in a spaced-apart relationship.

15. A printed circuit board comprised of a plurality of interconnected elements, wherein at least two elements to be connected (1, 2, 4, 5, 6, 10, 15, 16, I, II, III) of the printed circuit board are mechanically connected by gluing with one another on at least one peripheral region (7, 11, 28, 29) thereof, while keeping a distance (3) and being supported on a carrier element,
**characterized in that** the distance (3) between the mutually facing peripheral regions to be connected (7, 11, 28, 29) is selected to be 500 µm at most and, in particular, 200 µm at most.

16. A printed circuit board according to claim 15, **characterized in that** elements to be connected (15, 16) are arranged, and connected with one another, with reference to at least one aligning or registering element (17) provided on one of the elements to be connected.

17. A printed circuit board according to claim 15 or 16, **characterized in that** a thermally or chemically or UV or IR curable adhesive (12) is used for gluing.

18. A printed circuit board according to claim 17, **characterized in that** the adhesive (12) is merely introduced or arranged over a portion of the vertical extension of side edges of the peripheral regions to be connected (7, 11, 28, 29).

19. A printed circuit board according to any one of claims 15 to 18, **characterized in that** connected elements (I, II, III) of a printed circuit board are separable along the interconnected peripheral regions, e.g. for repair purposes, particularly by using a cutter or laser.

20. A printed circuit board according to any one of claims 15 to 19, **characterized in that** elements to be connected (6, 10), in a manner known per se, are each formed with at least one relatively complementary coupling element (8, 9) on peripheral regions to be connected (7, 11).

21. A printed circuit board according to claim 20, **characterized in that** the at least one coupling element (8) of an element to be connected (6) is formed by a profiled coupling element projecting from the peripheral region (7) of said element and received in a complementary recess (9) of the element (10) to be connected therewith, while keeping said distance.

22. The use of the method according to any one of claims 1 to 14 for the production of a multi-part circuit board.

## Revendications

1. Procédé de raccordement d'une pluralité d'éléments d'une carte de circuit imprimé, comprenant les étapes suivantes :
- la mise à disposition des éléments (1, 2, 4, 5, 6, 10, 15, 16, I, II, III) d'une carte de circuit imprimé avec des contours adaptés les uns aux autres,
- l'agencement des éléments (1, 2, 4, 5, 6, 10, 15, 16, I, II, III) à raccorder les uns aux autres dans un rapport de proximité spatial sur au moins une zone périphérique (7, 11, 28, 29) avec un contour complémentaire l'un à l'autre en respectant une distance (3) entre les zones périphériques (7, 11, 28, 29) tournées les unes vers les autres, et
- le raccordement mécanique par collage des zones périphériques (7, 11, 28, 29) tournées les unes vers les autres sur au moins une zone partielle de celles-ci pour le raccordement des éléments (1, 2, 4, 5, 6, 10, 15, 16, I, II, III) à raccorder les uns aux autres de la carte de circuit imprimé, dans lequel les éléments (6, 10) à raccorder l'un à l'autre d'une carte de circuit imprimé sont agencés ou en appui pour la réalisation du processus de raccordement sur un élément porteur (20, 30), les éléments (6, 10) de carte de circuit imprimé à raccorder l'un à l'autre sont maintenus bloqués pendant le processus de raccordement sur l'élément porteur (20, 30) par la création d'un vide, par un serrage, par une entrée d'élévations ou de tiges (31) dépassant de l'élément porteur (30) dans des évidements complémentaires (32) des éléments (6, 10) et/ou la surface dirigée vers les éléments à appuyer (6, 10) de l'élément porteur (20, 30) est formée en un matériau empêchant un glissement, par exemple un silicone, caoutchouc ou similaire ou est revêtue avec celui-ci,
**caractérisé en ce que** la distance (3) entre les zones périphériques (7, 11, 28, 29) à raccorder les unes aux autres et tournées les unes vers les autres est choisie avec 500 µm maximum, en particulier 200 µm maximum.

2. Procédé selon la revendication 1, **caractérisé en ce que** des éléments (15, 16) à raccorder l'un à l'autre sont agencés en référence à au moins un élément d'orientation ou d'enregistrement (17) agencé sur un des éléments à raccorder l'un à l'autre et sont raccordés l'un à l'autre.

3. Procédé selon la revendication 1 ou 2, **caractérisé en ce qu'**une colle (12) durcissant par voie thermique ou chimique ou au moyen de la lumière UV ou lumière IR est utilisée pour le collage.

4. Procédé selon la revendication 3, **caractérisé en ce qu'**un durcissement thermique de la colle (12) est entrepris à une température entre 80 °C et 300 °C.

5. Procédé selon la revendication 4, **caractérisé en ce qu'**une colle (12) à haute viscosité est utilisée.

6. Procédé selon l'une quelconque des revendications 1 à 5, **caractérisé en ce que** la colle (12) est appliquée au moyen d'un dispositif de sortie, d'une impression au pochoir, impression par sérigraphie ou similaire.

7. Procédé selon l'une quelconque des revendications 3 à 6, **caractérisé en ce que** la colle (12) est introduite ou agencée juste sur une zone partielle de l'étendue verticale d'arêtes latérales des zones périphériques (7, 11, 28, 29) à raccorder les unes aux autres.

8. Procédé selon l'une quelconque des revendications 1 à 7, **caractérisé en ce qu'**un raccordement provisoire de zones périphériques (7, 11, 28, 29) à raccorder les unes aux autres est réalisé en utilisant une bande ou étiquette adhésive (23) retirable.

9. Procédé selon l'une quelconque des revendications 1 à 8, **caractérisé en ce qu'**un élément de protection retirable (22) par exemple une couche de papier retirable est agencée sous les zones périphériques à raccorder les unes aux autres des éléments (6, 10) à raccorder l'un à l'autre.

10. Procédé selon l'une quelconque des revendications 1 à 9, **caractérisé en ce que** des éléments (I, II, III) raccordés les unes aux autres d'une carte de circuit imprimé sont séparés les uns des autres par exemple à des fins de réparation, en particulier en utilisant une fraise ou un laser, le long des zones périphériques raccordées les unes aux autres.

11. Procédé selon l'une quelconque des revendications 1 à 10, **caractérisé en ce que** des éléments (6, 10) à raccorder l'un à l'autre sont réalisés sur des zones périphériques (7, 11) à raccorder l'une à l'autre respectivement d'une manière connue en soi avec au moins un élément de couplage (8, 9) complémentaire l'un à l'autre.

12. Procédé selon la revendication 11, **caractérisé en ce que** l'au moins un élément de couplage (8) d'un élément (6) à raccorder l'un à l'autre est formé par un élément de couplage profilé, dépassant de la zone périphérique de l'élément qui est reçu dans un évidement (9) complémentaire de l'élément (10) à raccorder à celui-ci en respectant la distance (3).

13. Procédé selon la revendication 11 ou 12, **caractérisé en ce qu'**un élément (6) sensiblement rectangulaire d'une carte de circuit imprimé est pourvu sur des zones périphériques opposées respectivement les unes aux autres d'au moins un élément de couplage (8) respectif qui est raccordé à un élément de couplage (9) respectif d'un élément (10) de cadre ou de support coagissant avec celui-ci.

14. Procédé selon la revendication 11, 12 ou 13, **caractérisé en ce qu'**une pluralité d'éléments (1, 2, 4, 5, 6, 10, 15, 16, I, II, III) d'une carte de circuit imprimé est raccordée les uns aux autres à distance les uns des autres.

15. Carte de circuit imprimé, se composant d'une pluralité d'éléments raccordés les uns aux autres, dans laquelle au moins deux éléments (1 2, 4, 5, 6, 10, 15, 16, I, II, III) à raccorder les uns aux autres de la carte de circuit imprimé sont reliés mécaniquement sur au moins une zone périphérique (7, 11, 28, 29) de ceux-ci en respectant une distance (3) et en appuyant sur un élément de support entre eux par collage, **caractérisée en ce que** la distance (3) est choisie entre les zones périphériques (7, 11, 28, 29) à raccorder les unes aux autres et tournées les unes vers les autres avec 500 µm maximum, en particulier 200 µm maximum.

16. Carte de circuit imprimé selon la revendication 15, **caractérisée en ce que** des éléments (15, 16) à raccorder l'un à l'autre sont agencés en référence à au moins un élément d'orientation ou d'enregistrement (17) agencé sur un des éléments à raccorder l'un à l'autre et sont raccordés l'un à l'autre.

17. Carte de circuit imprimé selon la revendication 15 ou 16, **caractérisée en ce qu'**une colle (12) durcissant par voie thermique ou chimique ou au moyen d'une lumière UV ou lumière IR est utilisée pour le collage.

18. Carte de circuit imprimé selon la revendication 17, **caractérisée en ce que** la colle (12) est introduite ou agencée juste sur une zone partielle de l'étendue verticale d'arêtes latérales des zones périphériques (7, 11, 28, 29) à raccorder les unes aux autres.

19. Carte de circuit imprimé selon l'une quelconque des revendications 15 à 18, **caractérisée en ce que** des éléments (I, II, III) à raccorder les uns aux autres d'une carte de circuit imprimé sont séparables les uns des autres par exemple à des fins de réparation en particulier en utilisant une fraise ou un laser le long des zones périphériques raccordées les unes aux autres.

20. Carte de circuit imprimé selon l'une quelconque des revendications 15 à 19, **caractérisée en ce que** des éléments (6, 10) à raccorder l'un à l'autre sont réalisés sur des zones périphériques (7, 11) à raccorder l'une à l'autre d'une manière connue en soi respectivement avec au moins un élément de couplage (8, 9) complémentaire l'un à l'autre.

21. Carte de circuit imprimé selon la revendication 20, **caractérisée en ce que** l'au moins un élément de couplage (8) d'un élément (6) à raccorder l'un à l'autre est formé d'un élément de couplage profilé dépassant de la zone périphérique (7) de l'élément, qui est reçu dans un évidement (9) complémentaire de l'élément (10) à raccorder à celui-ci en respectant la distance.

22. Utilisation du procédé selon l'une quelconque des revendications 1 à 14 pour la fabrication d'une carte de circuit imprimé en plusieurs parties.
